(19) Europäisches Patentamt
European Patent Office
Office européen des brevets

(11) **EP 4 333 313 B1**

(12) **FASCICULE DE BREVET EUROPEEN**

(45) Date de publication et mention de la délivrance du brevet:
**18.03.2026 Bulletin 2026/12**

(51) Classification Internationale des Brevets (IPC):
**H04B 1/04** *(2006.01)* **H03M 3/00** *(2006.01)*
**H04B 7/06** *(2006.01)*

(21) Numéro de dépôt: **23193213.8**

(22) Date de dépôt: **24.08.2023**

(52) Classification Coopérative des Brevets (CPC):
**H04B 1/0483; H03M 3/414; H03M 3/50;**
**H04B 7/0617**

(54) **SYSTEME MULTIVOIES D'EMISSION ET/OU DE RECEPTION COMPRENANT AU MOINS N VOIES DE TRAITEMENT PARALLELES ET PROCEDE DE DECORRELATION DES BRUITS DE QUANTIFICATION DANS UN TEL SYSTEME**

MEHRKANALSENDE- UND/ODER EMPFANGSSYSTEM MIT MINDESTENS N PARALLELEN VERARBEITUNGSPFADEN UND VERFAHREN ZUR DEKORRELATION VON QUANTISIERUNGSRAUSCHEN IN EINEM SOLCHEN SYSTEM

MULTI-CHANNEL TRANSMISSION AND/OR RECEPTION SYSTEM COMPRISING AT LEAST N PARALLEL PROCESSING CHANNELS AND METHOD FOR DE-CORRELATION OF QUANTIZATION NOISE IN SUCH A SYSTEM

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **30.08.2022 FR 2208649**

(43) Date de publication de la demande:
**06.03.2024 Bulletin 2024/10**

(73) Titulaire: **Commissariat à l'Energie Atomique et aux Energies Alternatives**
**75015 Paris (FR)**

(72) Inventeurs:
• **MORCHE, Dominique**
**38054 GRENOBLE Cedex 09 (FR)**
• **VERDANT, Arnaud**
**38054 GRENOBLE Cedex 09 (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**WO-A1-2020/105040 US-A1- 2017 012 679**

• **JOS� M DE LA ROSA: "Sigma-Delta Modulators: Tutorial Overview, Design Guide, and State-of-the-Art Survey", IEEE TRANSACTIONS ON CIRCUITS AND SYSTEMS I: REGULAR PAPERS, IEEE, US, vol. 58, no. 1, 1 January 2011 (2011-01-01), pages 1 - 21, XP011340995, ISSN: 1549-8328, DOI: 10.1109/ TCSI.2010.2097652**
• **AZIZ P M ET AL: "Multi band sigma delta analog to digital conversion", PROCEEDINGS OF ICASSP '94. IEEE INTERNATIONAL CONFERENCE ON ACOUSTICS, SPEECH AND SIGNAL PROCESSING; 19-22 APRIL 1994; ADELAIDE, SA, AUSTRALIA, IEEE SERVICE CENTER, PISCATAWAY, NJ, vol. iii, 19 April 1994 (1994-04-19), pages III/249 - III/252, XP010134210, ISBN: 978-0-7803-1775-8, DOI: 10.1109/ ICASSP.1994.390021**

**Description**

**Domaine technique :**

L'invention se situe dans le domaine des systèmes d'émission ou réception multivoies

**Technique antérieure :**

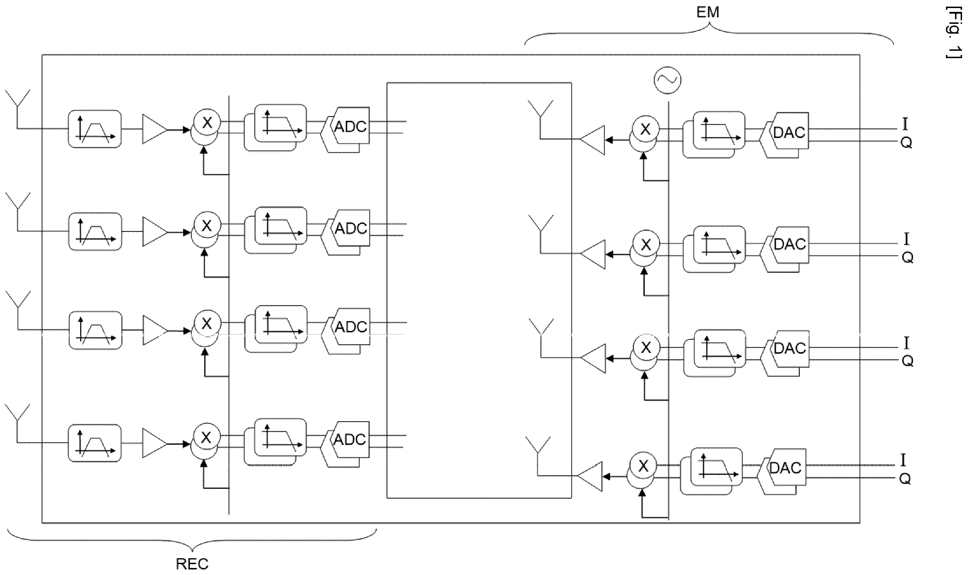

Un exemple d'architecture de système d'émission-réception multivoies de type radiofréquence est représenté en figure 1, comportant plusieurs voies de traitement parallèle en émission et en réception, tant pour les signaux I que pour les signaux Q dans une représentation en quadrature. Chaque voie en émission comporte en réalité une voie I et une voie Q, pour traiter chacune la composante correspondante du signal d'entrée comportant deux composantes en quadrature. Chacune des voies I, Q comporte notamment un convertisseur numérique-analogique (DAC), un filtre passe-bas de mise en forme, un étage de changement de fréquence. Chaque voie en émission comporte en outre un amplificateur et une antenne d'émission. Chaque voie en réception comporte notamment une antenne de réception, un filtre passe-bande, un amplificateur, et comporte également une voie I et une voie Q comprenant chacune un étage de changement de fréquence, un filtre passe-bas et un convertisseur analogique-numérique (ADC).

Il est souvent nécessaire, dans les architectures de ce type utilisées par exemple pour effectuer du beamforming numérique, d'avoir un grand nombre de ces voies en parallèle afin d'obtenir un gain important dans la direction visée. Ce grand nombre de voies entraîne une surface de silicium importante et peut entraîner un nombre d'entrée/sortie importante. Pour limiter le nombre d'entrée/sortie, il est possible d'utiliser le même signal numérique en entrée de toutes les voies (I, respectivement Q) et d'effectuer le beamforming en opérant un retard différent (et/ou en opérant un déphasage des signaux) sur chacune des voies, pour compenser la différence de temps de vol entre les signaux. Même si le traitement en bande de base est intégré dans le chip, avoir une seule entrée va réduire la complexité du routage digital. Le retard peut aussi être intégré au DAC en effectuant tout ou partie du retard sur le retard de l'horloge du DAC.

Pour avoir un bon rapport signal à bruit (SNR pour l'anglais « Signal To Noise Ratio ») dans la bande passante du signal et atteindre un débit élevé, il est intéressant de disposer d'un nombre de bits élevé dans le DAC afin de réduire le bruit de quantification. L'augmentation de l'ordre des modulations dans les systèmes actuels a tendance à augmenter les contraintes sur le SNR et donc augmenter le nombre de bits du DAC. Ce nombre de bits élevé est gênant parce qu'il implique une complexité importante pour le DAC (qui va engendrer une forte surface et une consommation élevée). La contrainte sur le SNR du DAC est d'autant plus importante que lorsque chaque DAC reçoit le même signal, le bruit de quantification va être le même sur toutes les voies ; ce bruit s'ajoute de façon cohérente lors de la formation du faisceau et sa puissance augmente en $20\log(N)$ où N est le nombre de voies.

Des solutions existent pour essayer de réduire la corrélation du bruit de quantification entre les voies. Du bruit (« dither »), différent sur chacune des voies, peut être injecté. Cela permet de limiter l'augmentation du bruit de quantification à $10\log(N)$. Mais cette solution augmente la complexité puisqu'il faut générer N sources de bruit non corrélées, injecter le bruit généré dans le DAC en analogique, puis supprimer ce signal en sortie. Ce signal (dither) pourra augmenter la contrainte de dynamique du signal et peut créer des contraintes fortes de linéarité sur le DAC en augmentant le signal qui circule dans ce DAC.

Une des solutions utilisées dans l'état de l'art est de positionner un codeur sigma-delta en amont du DAC : cf. WO2020105040 A1. Cette solution permet de réduire le nombre de bits du DAC (et donc de réduire la consommation et la surface) en contrepartie d'avoir une fréquence d'échantillonnage élevée, pour bénéficier d'un bon facteur de sur-échantillonnage, ce qui est nécessaire au codage sigma-delta. Cette contrainte n'est pas forcément gênante dans l'architecture d'émission puisqu'il est habituel d'utiliser une fréquence d'échantillonnage élevée dans le DAC d'émission pour ne pas contraindre trop le filtre analogique suivant ce même DAC. Un des inconvénients de cette architecture est que le bruit de quantification dont la puissance augmente en fonction de la fréquence dès la fin de la bande passante du signal doit être filtré par un filtre analogique avec une faible fréquence de coupure. Ce qui apporte des contraintes fortes sur le filtre analogique.

Avec l'utilisation d'un codeur sigma-delta pour effectuer la compression des données, il existe des solutions simples pour dé-corréler le bruit de quantification entre toutes les voies. Certaines de ces solutions sont proposées dans WO2020105040 A1.

Une première solution consiste à effectuer des manipulations des données entre la sortie du codeur sigma-delta et l'entrée du convertisseur numérique-analogique. Cette solution est d'un intérêt limité puisque lorsque le nombre de voies est élevé, elle impose d'avoir une permutation sur une longue séquence pour avoir suffisamment de possibilités de combinaison différents, ce qui augmente la complexité de la partie brassage des données.

Les autres solutions consistent à modifier les codeurs sigma-delta de façon différente sur chacune des voies. Une solution est d'ajouter une valeur constante (dc offset) à l'entrée du quantificateur 1 bit. Cette option est simple d'utilisation, par contre elle a l'inconvénient de ne pas casser le rythme des séquences périodiques du codeur sigma-delta et donc de conserver des « tones » identiques entre les voies (concentration de bruit à des fréquences proches). Une autre solution du même type consiste à faire démarrer les codeurs sigma-delta à des instants différents. C'est tout à fait efficace vis-à-vis de la décorrélation du bruit de quantification, mais comme dans le cas précédent, on va se retrouver avec des séquences de bruit qui peuvent se trouver juste décalées les unes par rapport aux autres et donc avoir des tones qui sont aux mêmes fréquences, sur chacune des voies. Une autre solution est de fournir des états initiaux différents dans chacune des voies, ce qui conduit au même type de résultat.

Un troisième type de solution proposée consiste à modifier les coefficients du filtre du codeur sigma-delta de façon différente sur chacune des voies. Ainsi, les séquences du codeur seront différentes entre elles et les bruits ne seront pas corrélés. L'inconvénient est une prise de risque sur la stabilité du codeur sigma-delta (en modifiant les coefficients, on vient modifier les pôles) ainsi qu'une modification de la fonction de transfert du signal d'entrée qui peut perturber la qualité du système d'émission.

US 2017/012679 A1 décrit un agencement d'antenne pour la formation de faisceau numérique d'un signal d'émission comportant : un nombre N > 1 de convertisseurs numérique-analogique, CNA, chacun des N CNA étant agencé pour recevoir une composante de signal numérique d'émission respective, et pour convertir et sortir une composante de signal d'émission analogique, chacun des N CNA ayant une résolution respective au-dessous de la résolution requise pour satisfaire à une exigence radio réglementaire dans un agencement d'antenne interchangeable agencé pour l'émission par un seul élément d'antenne connecté à un CNA unique ; et N éléments d'antenne, chacun des N éléments d'antenne étant conçu pour recevoir une composante de signal d'émission analogique et pour émettre la composante de signal d'émission analogique en tant que partie du signal d'émission formé par faisceau numérique.

Ainsi, il existe soit des solutions très simples, qui n'impactent pas le signal, mais qui ne décorrélent pas complétement le bruit d'une voie par rapport aux autres, ce qui peut présenter un risque si le bruit n'est pas complètement blanc, soit des solutions plus complexes qui peuvent avoir un impact sur le signal lui-même, en modifiant la fonction de transfert du signal et présenter des risques d'instabilité.

## Résumé de l'invention :

A cet effet, suivant un premier aspect, la présente invention décrit un système multivoies d'émission et/ou de réception comprenant au moins N voies de traitement parallèles, N ≥ 2, couplées chacune à un transducteur et comportant chacune un bloc convertisseur comprenant un convertisseur CAN ou CNA et un modulateur sigma-delta,

la fonction de transfert du modulateur sigma-delta de chaque voie Vi, i = 1 à N, étant définie comme une somme de deux termes comprenant un premier terme IN(z).FTS(z) relatif au signal et un deuxième terme Q(z).FTB(z) relatif au bruit de quantification et s'énonçant ainsi :

$$OUT(z) = IN(z).FTS(z) + Q(z).FTB(z),$$

où OUT est le signal de sortie du modulateur sigma-delta, IN est le signal d'entrée du modulateur sigma-delta, FTS est la fonction de transfert du signal d'entrée, Q est le bruit de quantification et FTB est la fonction de transfert du bruit de quantification,

la fonction de transfert du modulateur sigma-delta d'une voie Vi étant distincte de la fonction de transfert du modulateur sigma-delta d'une voie Vj, i et j entiers distincts compris entre 1 et N, pour décorréler entre eux les bruits de quantification de voies distinctes,

ledit système multivoies étant caractérisé en ce que les deuxièmes termes de la fonction de transfert du modulateur sigma-delta uniquement sont distincts, le premier terme de ladite fonction de transfert pour la voie Vi étant égal à celui pour la voie Vj.

Ainsi l'invention permet d'éviter que les bruits de quantification issus des différentes voies ne s'ajoutent de façon cohérente, sans présenter les inconvénients pré-cités des solutions de l'art antérieur : la fonction de transfert du signal n'est pas modifiée entre les différentes voies, la qualité du signal et la stabilité sont assurés.

Dans des modes de réalisation, un tel système comprendra en outre l'une au moins des caractéristiques suivantes :

- le modulateur sigma-delta sur chacune des voies Vi, Vj comprend un quantificateur 1 bit à hystérésis, et le cycle d'hystéresis est différent entre les voies Vi, Vj en amplitude et/ou temporellement ;

- le modulateur sigma-delta sur chacune des voies Vi, Vj comprend un quantificateur multibit ; et la valeur du signal d'entrée correspondant à la commutation entre deux niveaux de quantification sur la voie Vi est fixée distincte de la valeur du signal d'entrée correspondant à la commutation entre ces deux mêmes niveaux de quantification sur la voie Vj ;

- le système multivoies d'émission et/ou de réception comprend sur chacune des voies Vi, Vj, au moins ledit modulateur sigma-delta avec quantificateur multibit et un modulateur sigma-delta additionnel, la sortie de l'un desdits modulateurs étant fournie en entrée de l'autre desdits modulateurs, ledit autre modulateur sigma-delta sur la voie Vi étant identique à ledit autre modulateur sigma-delta sur la voie Vj ;

    le système multivoies d'émission et/ou de réception comprend sur chacune des voies Vi, Vj, un modulateur sigma-delta à architecture cascadée comprenant au moins deux étages, le premier étage comprenant un premier modulateur delta-sigma comprenant notamment un quantificateur et le deuxième étage comprenant au moins un deuxième modulateur sigma-delta ;

    le deuxième étage étant adapté pour recevoir en entrée la sortie du quantificateur du premier modulateur et l'entrée du quantificateur du premier modulateur, pour numériser, via le deuxième comparateur, un signal représentatif du bruit de quantification du premier modulateur et pour le mettre en forme ;

    la différence entre un signal proportionnel à la sortie du quantificateur du premier modulateur et un signal proportionnel à l'entrée du quantificateur du premier modulateur étant fournie en entrée du deuxième modulateur ;

    la sortie du deuxième étage étant ensuite soustraite à la sortie du premier modulateur pour délivrer un signal dépourvu d'au moins une partie du bruit de quantification du premier étage

    dans lequel le deuxième étage de la voie Vi est différent du deuxième étage sur la voie Vj de manière de manière à différentier entre eux les bruits de quantification du deuxième modulateur des voies Vi, Vj ;

- le deuxième étage comporte des multiplieurs, chaque multiplieur multipliant son entrée par un coefficient associé respectif, dans lequel, en considérant au moins un desdits multiplieurs, le coefficient qui lui est associé sur la voie Vi est de valeur différente de celui sur la voie Vj ;

- un bloc retardateur est disposé dans le deuxième étage, entre la sortie du premier modulateur et l'entrée du deuxième modulateur, adapté pour appliquer un retard au signal issu de ladite sortie, le retard sur la voie Vi étant fixé à une valeur différente de celle du retard sur la voie Vj.

Suivant un autre aspect, l'invention décrit un procédé de décorrélation des bruits de quantification dans un système multivoies démission et/ou de réception comprenant au moins N voies de traitement parallèles, N ≥2, couplées chacune à un transducteur et comportant chacune un bloc convertisseur comprenant un convertisseur CAN ou CNA et un modulateur sigma-delta,

    la fonction de transfert du modulateur sigma-delta de chaque voie Vi, i = 1 à N, étant définie comme une somme de deux termes comprenant un premier terme IN(z).FTS(z) relatif au signal et un deuxième terme Q(z).FTB(z) relatif au bruit de quantification et s'énonçant ainsi :

$$OUT(z) = IN(z).FTS(z) + Q(z).FTB(z),$$

    où OUT est le signal de sortie du modulateur sigma-delta, IN est le signal d'entrée du modulateur sigma-delta, FTS est la fonction de transfert du signal d'entrée, Q est le bruit de quantification et FTB est la fonction de transfert du bruit de quantification,

    selon lequel le fonctionnement du modulateur sigma-delta de la voie Vi est adapté par rapport au fonctionnement du modulateur sigma-delta de la voie Vj pour décorréler les bruits de quantification générés par les voies,

    la fonction de transfert du modulateur sigma-delta d'une voie Vi étant distincte de la fonction de transfert du modulateur sigma-delta d'une voie Vj, i et j entiers distincts compris entre 1 et N, pour décorréler entre eux les bruits de quantification de voies distinctes,

ledit procédé étant caractérisé en ce que les deuxièmes termes de la fonction de transfert du modulateur sigma-delta uniquement sont distincts, le premier terme de ladite fonction de transfert pour la voie Vi étant égal à celui pour la voie Vj.

Dans des modes de réalisation, un tel procédé comprendra en outre l'une au moins des caractéristiques suivantes :

- le modulateur sigma-delta sur chacune des voies Vi, Vj comprend un quantificateur 1 bit à hystérésis, et le cycle d'hystéresis est différent entre les voies Vi, Vj en amplitude et/ou temporellement ;

- le modulateur sigma-delta sur chacune des voies Vi, Vj comprend un quantificateur multibit ; et la valeur du signal d'entrée correspondant à la commutation entre deux niveaux de quantification sur la voie Vi est fixée distincte de la valeur du signal d'entrée correspondant à la commutation entre ces deux mêmes niveaux de quantification sur la voie Vj.

**Brève description des figures :**

L'invention sera mieux comprise et d'autres caractéristiques, détails et avantages apparaîtront mieux à la lecture de la description qui suit, donnée à titre non limitatif, et grâce aux figures annexées, données à titre d'exemple.

[Fig. 1] La figure 1 est une illustration d'architecture de système d'émission-réception multivoies dans l'Art Antérieur (AA) ;

[Fig. 2] La figure 2 est une illustration d'un système d'émission multivoies dans un mode de réalisation de l'invention ;

[Fig. 3] La figure 3 est un schéma d'un modulateur sigma-delta à une cellule du premier ordre ;

[Fig. 4] La figure 4 est un graphe montrant la caractéristique d'un quantificateur d'un modulateur sigma-delta à deux niveaux de sortie dans un mode de réalisation de l'invention ;

[Fig. 5] La figure 5 illustre un mode de réalisation d'un quantificateur présentant la caractéristique de la figure 4 ;

[Fig. 6] La figure 6 illustre un autre mode de réalisation d'un quantificateur présentant la caractéristique de la figure 4 ;

[Fig. 7] La figure 7 est un graphe montrant une partie de la caractéristique d'un quantificateur d'un modulateur sigma-delta à trois niveaux de sortie au moins dans un mode de réalisation de l'invention;

[Fig. 8] La figure 8 est une illustration d'un système d'émission multivoies dans un mode de réalisation de l'invention ;

[Fig. 9] La figure 9 est une illustration d'un modulateur sigma-delta à deux étages à l'architecture connue de l'art antérieur ;

[Fig. 10] La figure 10 est une illustration d'un procédé de décorrélation des bruits de quantification dans un système d'émission- réception multivoies dans un mode de réalisation de l'invention.

Des références identiques peuvent être utilisées dans des figures différentes lorsqu'elles désignent des éléments identiques ou comparables.

**Description détaillée :**

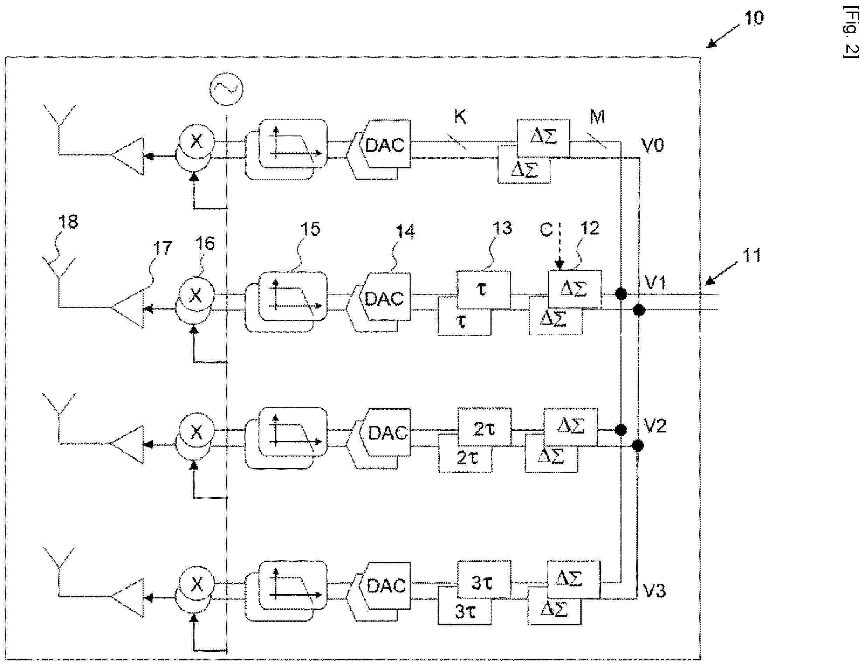

Un système d'émission multivoies 10, par exemple de type radiofréquence mis en œuvre dans le cadre d'une application de beamforming en ondes millimétriques, comprend dans un mode de réalisation de l'invention illustré à la figure 2, un bloc de conversion numérique-analogique intégré par exemple dans un SOC et comportant N voies de traitement parallèles Vi, i = 0 à N-1, avec N entier supérieur ou égal à 2. Dans le cas représenté, N est égal à 4.

On notera que chaque voie de traitement Vi comprend en réalité deux voies, une voie I et une voie Q, pour traiter chacune la composante correspondante du signal d'entrée comportant deux composantes en quadrature. Quand on parlera de chaque voie de traitement ci-après, on entendra chaque voie de traitement parmi les N voies de traitement du signal I par exemple (ou chaque voie de traitement parmi les N voies de traitement du signal Q).

Chaque voie de traitement Vi reçoit en entrée un même signal numérique 11.

La voie de traitement Vi, i = 0 à N-1, comporte successivement un modulateur sigma-delta 12, un retardateur 13 retardant le signal d'un délai $i.\tau$, un convertisseur numérique-analogique 14, un filtre passe-bas 15, un étage de changement de fréquence 16 pour effectuer la mise sur porteuse, un amplificateur 17 et est couplée à une antenne d'émission radiofréquence 18.

Dans des modes de réalisation, le système d'émission 10 comporte un bloc de contrôle (non représenté), adapté pour générer des signaux de commande C destinés aux modulateurs sigma-delta 12, pour piloter les décorrélations des bruits de quantification le cas échéant.

Le modulateur sigma-delta est ici un modulateur sigma-delta numérique-numérique qui reçoit un train de bits, avec une précision de M bits et délivre un train de bits avec une précision de K bits, avec K< M et K, M nombres entiers.

Un modulateur sigma-delta 12 est, de façon connue, un dispositif à boucle de rétroaction effectuant un encodage sur un faible nombre de bits (par exemple égal à 1, à 2, inférieur à 5...), et une fréquence d'échantillonnage élevée par rapport à la bande passante du signal à encoder. Ce dispositif met en forme le spectre du bruit de quantification en repoussant sa puissance dans une bande de fréquence non occupée par le spectre du signal utile. Cette séparation spectrale permet, grâce à un filtrage du signal encodé, de conserver un rapport signal à bruit conforme à des spécifications données.

Un modulateur sigma-delta comprend, de façon générale :

une entrée pour recevoir un signal d'entrée qui, selon les utilisations, est analogique ou, comme dans l'exemple considéré, numérique, codé sur M bits ;

une sortie pour délivrer une valeur numérique de sortie codée sur K bits ; et,

une ou plusieurs cellules sigma-delta disposées entre l'entrée et la sortie du modulateur.

Chaque cellule peut être du premier ordre ou d'un ordre supérieur. Notamment, certaines peuvent être du premier ordre, et d'autres d'un ordre supérieur.

Chaque cellule sigma-delta comprend au minimum les éléments suivants :

un soustracteur comprenant une première entrée, une seconde entrée, et une sortie, la première entrée étant couplée à l'entrée du modulateur pour recevoir le signal d'entrée ou une valeur dérivée de celle-ci ;

un intégrateur comprenant une entrée couplée à la sortie du soustracteur, et une sortie ; et,

un quantificateur ayant une entrée couplée à la sortie de l'intégrateur et une sortie couplée à la seconde entrée du soustracteur ; la sortie du quantificateur est, en outre, couplée à la sortie du modulateur pour délivrer la valeur numérique de sortie ou une contribution à celle-ci.

Chaque cellule sigma-delta est caractérisée par sa fonction de transfert, reliant son signal de sortie OUT à son signal d'entrée IN et au bruit de quantification Q du quantificateur. La fonction de transfert (transformée en z) s'écrit ainsi :

$$OUT(z) = IN(z).STF(z) + Q(z).NTF(z)$$

où STF est la fonction de transfert de signal d'entrée (en anglais Signal Transfer Function) et NTF est la fonction de transfert de bruit (en anglais Noise Transfer Function), exprimées ici en fonction de la fréquence ; Q est le bruit de quantification, égal à la différence entre la sortie du quantificateur et l'entrée du quantificateur.

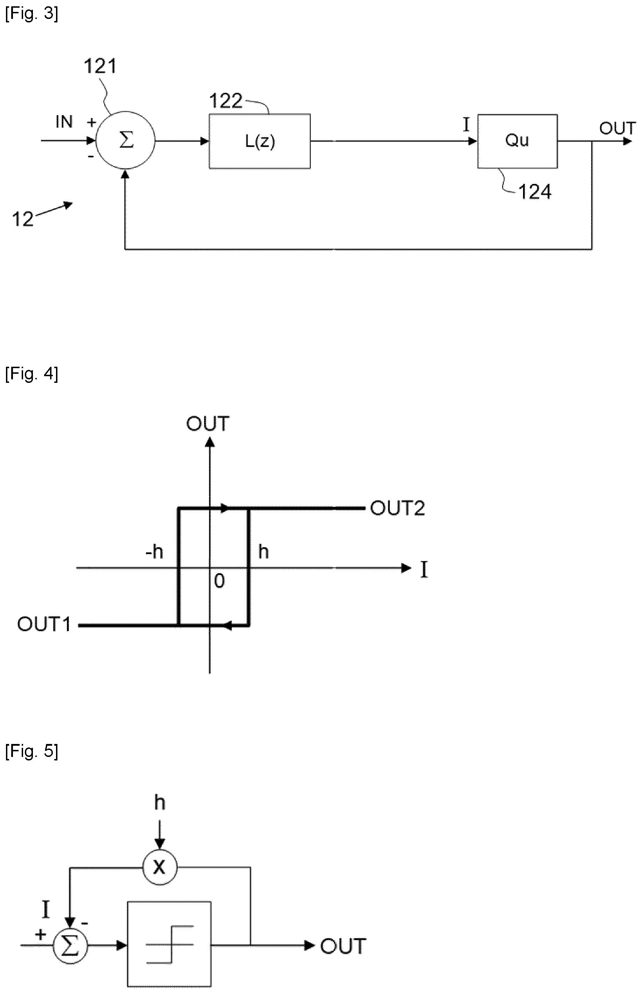

La figure 3 représente schématiquement un modulateur sigma-delta 12 à une cellule du premier ordre, avec un signal d'entrée IN, un signal de sortie OUT, un soustracteur 121, un intégrateur 122 et un quantificateur 124.

L est la fonction de filtre de boucle. Elle est, de façon connue, une fonction de filtre passe-bas à gain très élevé aux basses fréquences. Le filtre de boucle peut être mis en œuvre comme un simple intégrateur ou comme une cascade d'intégrateurs (quand le signal d'entrée est analogique, un DAC est en outre placé sur le chemin de retour pour prendre le signal de sortie numérique et le ramener en entrée du soustracteur en analogique).

Dans le cas de la figure 3, $STF(f) = \dfrac{L(f)}{1+L(f)}$ et $NTF(f) = \dfrac{1}{1+L(f)}$.

La fonction de transfert du signal d'entrée fonctionne avec un gain de 1 dans la bande passante d'intérêt. La fonction de transfert de bruit est une fonction de filtre passe-haut, fournissant la mise en forme du bruit : forte suppression du bruit de quantification dans les basses fréquences tandis que le bruit de quantification aux hautes fréquences endehors de la bande passante est accru.

L'invention consiste à décorréler les bruits de quantification entre les différentes voies, en agissant uniquement sur la part « Q.NTF(z) », sans modifier la fonction de transfert de signal, pour garantir stabilité et qualité du signal. La part « IN.STF(z) » est donc la même pour les différentes voies de traitement (ce qui évite la contrainte de réaliser une étude de stabilité lors de la conception du système d'émission, au contraire des solutions de WO2020105040 A1), la part « Q.NTF(z) » diffère au moins pour certaines des voies.

Dans un premier mode de réalisation de l'invention, les bruits de quantification sont décorrélés entre deux voies de traitement par l'utilisation, dans le modulateur sigma-delta 12 de chaque voie, d'un quantificateur 1 bit à hystéresis, l'hystérésis appliquée sur une voie Vi étant différente de celle appliquée sur la voie Vj, avec i, j entiers distincts compris entre 0 et N.

Dans un tel cas, en référence à la figure 4 :

- à la place d'avoir, sur chaque voie de traitement, la sortie du quantificateur qui commute entre OUT1 et OUT2 (les deux niveaux de quantification du quantificateur 1 bit) quand I franchit la valeur Seuil (de valeur 0 sur la figure 4, mais la valeur Seuil peut prendre une autre valeur prédéterminée dans d'autres modes de réalisation),

- la fonction de transfert du quantificateur 124 est modifiée de façon à ce que le fonctionnement soit le suivant : quand le signal I est inférieur à la valeur Seuil, la valeur de commutation est égale à Seuil1, inférieure à la valeur Seuil (dans le cas présenté en figure 4 : valeur Seuil - h, avec h nombre réel) et quand le signal I est supérieur à la valeur Seuil, la valeur de commutation est égale à Seuil2, supérieure à la valeur Seuil (dans le cas présenté en figure 4 : valeur Seuil + h).

La valeur Seuil autour de laquelle a lieu l'hystérésis est la même pour les voies Vi, Vj.

La figure 5 illustre une implémentation fonctionnelle possible d'un tel quantificateur 1 bit (ou comparateur) à hystérésis, mettant en œuvre un comparateur à zéro et un multiplieur.

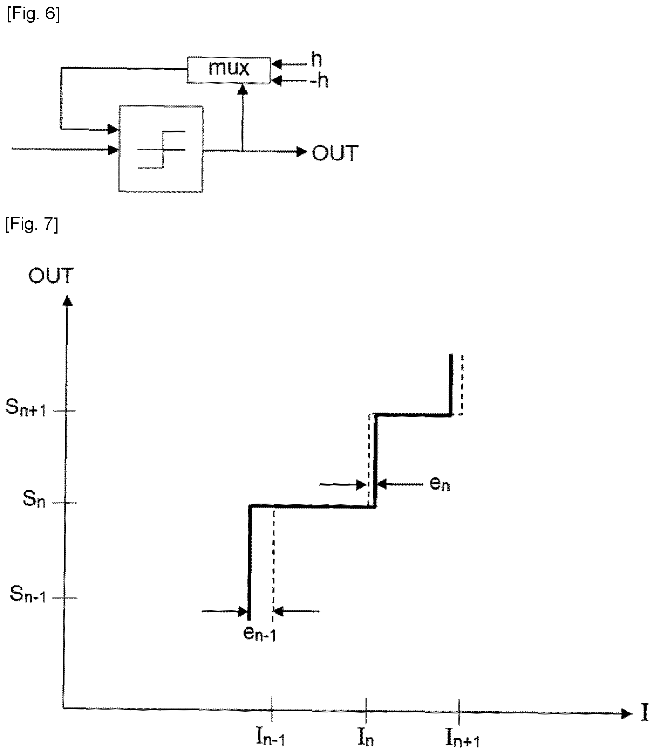

Une autre solution pour l'implémentation fonctionnelle est d'utiliser, comme représenté en figure 6, un comparateur à seuil et un multiplexeur qui choisira h ou - h en fonction du niveau de sortie du comparateur, ce qui évite l'implémentation d'un multiplieur.

Dans ce mode de réalisation, des valeurs d'hystérésis différentes entre elles sont utilisées sur des voies distinctes Vi, Vj. Ainsi, même avec une même entrée constante 11, les bruits vont avoir des cycles différents et vont être décorrélés les uns des autres.

Les valeurs d'hystérésis respectives sont par exemple commandées via une commande C générée par le bloc de contrôle.

L'hystérésis aura une valeur faible (h par exemple de valeur inférieure ou égale à 1/10, ou encore inférieure ou égale à 1/1000 par exemple) pour limiter l'impact sur le bruit de quantification. En effet, plus l'hystérésis est élevée, plus la puissance du bruit de quantification pourra être importante. Une autre possibilité est que la valeur d'hystérésis, h, dans chaque voie (ou au moins une des voies) est commandée pour varier au cours du temps, pour limiter l'impact de cet hystérésis.

Dans un mode de réalisation, les valeurs d'hystérésis sur deux voies Vi, Vj distinctes sont fixées de manière à ce que les différences minimales suivantes soient respectées entre deux voies.

Dans un mode de réalisation, une même valeur d'hystérésis h est utilisée sur différentes voies, voire sur toutes les voies, mais l'hystérésis est commandée (par exemple par une commande C) de façon à intervenir à des instants respectifs différents, les fonctions de transfert des quantificateurs ne se superposant donc pas pour deux voies distinctes.

On notera que l'hystérésis peut être à inversion ou pas, c'est-à-dire qu'il peut y avoir une addition ou une soustraction dans la boucle de retour et que le cycle d'hystérésis peut ne pas être symétrique par rapport à la valeur Seuil.

Dans un autre mode de réalisation de l'invention, le modulateur sigma-delta 12 comporte cette fois un quantificateur 124 qui prend la forme d'un quantificateur multibit, qui comporte donc 3 seuils distincts de quantification ou davantage. Dans un système multivoies, il est intéressant de réduire le nombre de bits du DAC sans forcément viser un DAC 1bit, le convertisseur 1 bit posant un certain nombre de problèmes de stabilité pour les modulateurs d'ordre élevé.

Dans ce mode de réalisation, on distingue une voie d'une autre par une modification propre à la voie sur un ou plusieurs des seuils de quantification du quantificateur multibit 124 présent dans cette voie, comme représenté en figure 7.

La fonction de transfert en pointillés est la fonction de transfert « idéale » du quantificateur 124 avec des seuils de quantification $I_1$, $I_2$, ... $I_p$, répartis de façon régulière (pour n =1 à p, nombre de seuils de quantification, la valeur de sortie OUT est égale à $S_n$ pour une valeur d'entrée I comprise entre $I_{n-1}$ et $I_n$). La fonction de transfert réelle du quantificateur 124 telle qu'implémentée est celle en traits pleins sur laquelle, pour chacun ou certains des seuils, il est introduit un décalage du seuil de quantification par rapport à la fonction de transfert idéale : la valeur de sortie OUT est égale à $S_n$ pour une valeur d'entrée I comprise entre $(I_{n-1} - e_{n-1})$ et $(I_n - e_n)$. Ainsi les valeurs de $S_1$, $S_2$, ... , $S_p$, $I_0$, $I_1$, $I_2$,..., $I_p$, ... sont les mêmes d'une voie à l'autre, mais chaque valeur de décalage $e_0$, ... $e_p$ (ou au moins une, voire certaines d'entre elles) est fixée de sorte qu'elle varie d'une voie à l'autre, permettant la décorrélation des bruits de quantification.

Dans un mode de réalisation, ces valeurs, propres aux voies, sont commandées par un signal de commande C généré par le bloc de contrôle.

L'impact de ce décalage sera faible puisque la valeur de décalage sera faible par rapport au pas de quantification q, typiquement les valeurs de décalage sont fixées de manière à être comprise entre 0.001q et 0.1q.

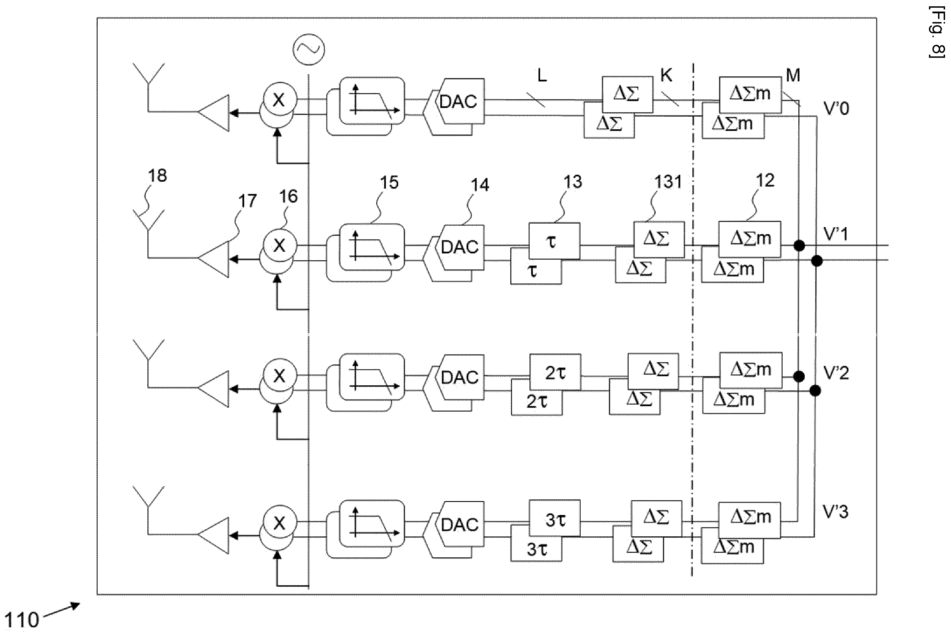

Dans un mode de réalisation d'un système d'émission multivoies 110 implémentant cette solution et représenté en figure 8, dans chaque voie de traitement Vi se trouvent deux modulateurs sigma-delta 12, 131 successifs, la sortie de l'un étant reliée à l'entrée de l'autre. Le premier modulateur sigma-delta 12 dispose d'un quantificateur multi-bit dont les seuils sont modifiés par injection de décalage comme expliqué ci-dessus et qui va comprimer le signal sur K bits (K<M) à une fréquence d'échantillonnage Fs1. L'optimisation du nombre de bits et de la fréquence d'échantillonnage peut être choisie pour minimiser le débit de données. La sortie de ce premier codeur sigma delta 12 est ensuite injectée dans le second modulateur sigma-delta 131 fonctionnant à une fréquence Fs2 qui va encore comprimer le signal, sur L bits (L<K), L= 1 bit par exemple. L'avantage de cette structure est que le signal du second modulateur 1 bit dispose d'un signal d'entrée avec un bruit de quantification du premier étage déjà décorrélé d'une voie à une autre. On peut placer un bloc de filtrage et/ou de sur-échantillonnage entre les deux étages de modulateurs pour optimiser de façon dissociée les deux modulateurs et pour filtrer une partie du bruit de quantification du premier étage. L'avantage de ce bruit introduit au niveau du premier quantificateur par rapport à un bruit introduit en entrée est que ce bruit est mis en forme par le modulateur sigma-delta.

Les modulateurs sigma-delta 131 utilisés sur les différentes voies peuvent, eux, être identiques dans un mode de réalisation.

Cette cascade de deux sigma-delta est plus facile à intégrer sur un même circuit intégré, et permet de mieux optimiser l'interface représentée en pointillé sur la figure 8, par rapport au cas où un seul modulateur sigma-delta serait utilisé pour passer de M bits à L bits (avec dans un tel cas l'alternative suivante à respecter : soit très haute résolution avec faible débit, soit très faible résolution avec un haut débit), sachant que le signal en entrée du modulateur 12, qui vient du système de communication numérique, a un nombre de bits élevé (résolution typiquement 10 ou 12 bits avec un débit fonction de la modulation des données par exemple 50 Mb/s), alors qu'il est souhaitable de réduire les contraintes au niveau du DAC 14 (par exemple L=1 bit et fréquence d'échantillonnage très élevée).

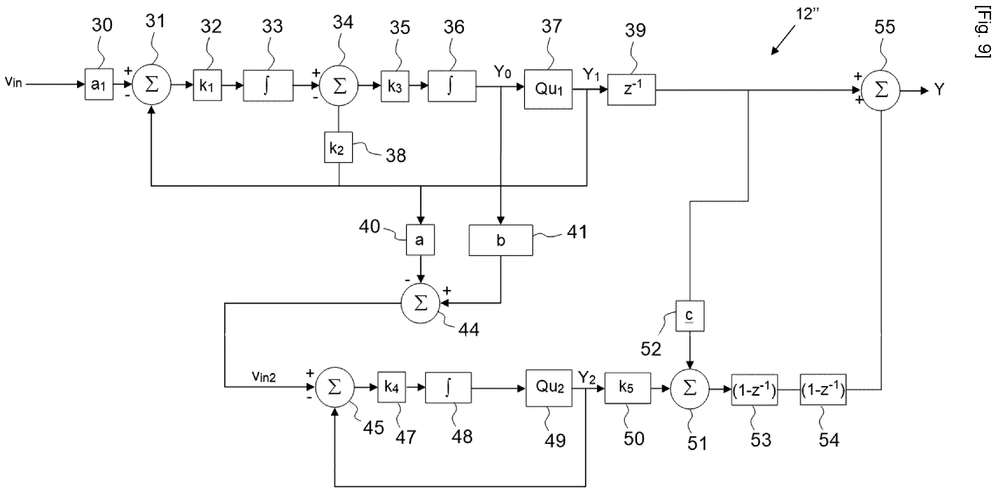

Dans un autre mode de réalisation de l'invention, le modulateur sigma-delta 12 de la figure 2 est alors un modulateur sigma-delta à architecture cascadée 12", dont l'architecture - connue - est représentée en figure 9 dans un exemple.

Ce modulateur sigma-delta à architecture cascadée 12" comprend dans le cas représenté deux modulateurs sigma-delta. Le premier modulateur sigma-delta est ici d'ordre 2. Il reçoit en entrée un signal $v_{in}$ et comporte des blocs respectifs 30, 32, 35, 38 multipliant le signal qui leur est respectivement fourni en entrée par le coefficient respectif $a_1$, $k_1$, $k_2$, $k_3$, deux intégrateurs 33, 36, un quantificateur 37, deux soustracteurs 31, 34.

L'entrée du quantificateur 37 est fournie en entrée d'un multiplicateur 40 par un coefficient a, la sortie du quantificateur 37 est fournie en entrée d'un multiplicateur 41 par un coefficient b, les sorties des multiplicateurs 40, 41 sont fournies en entrée d'un soustracteur 44 délivrant le signal $v_{in2}$ en entrée du deuxième modulateur sigma-delta.

Le deuxième modulateur sigma-delta est ici d'ordre 1. Il comporte un soustracteur 45, un bloc 47 multipliant le signal qui lui est respectivement fourni en entrée par le coefficient respectif $k_4$, un intégrateur 48 et un quantificateur 49.

La sortie $Y_2$ du deuxième modulateur sigma-delta est ajoutée à la sortie $Y_1$ du premier modulateur multipliée par la fonction de transfert $z^{-1}$ et par le coefficient c ; le résultat de la somme est multiplié à deux reprises par la fonction de transfert $(1 - z^{-1})$ ; le signal résultant est sommé à $Y_1$. $z^{-1}$ dans le sommateur 55, qui délivre en sortie le signal Y.

Le principe de fonctionnement est le suivant : le premier modulateur traite le signal d'entrée $v_{in}$ et délivre le signal numérique $Y_1$ :

$$Y_1(z) = a_1 . v_{in}(z) . FTS1(z) + Q_1(z) . FTB1(z)$$

où $v_{in}(z)$ est le signal d'entrée, $Q_1(z)$ le bruit de quantification du quantificateur du premier modulateur, FTS1(z) la fonction de transfert du signal d'entrée et FTB1(z) la fonction de transfert du bruit. Ici FTS1(z) est égale, dans une approximation, à $z^{-2}$ et FTB1(z) est égale, dans une approximation, à $(1-z^{-1})^2$, les erreurs d'approximation étant fonction de $k_1$, $k_2$, $k_3$.

Le bruit de quantification du premier quantificateur 37 est extrait en faisant la différence entre le signal de sortie et le signal d'entrée dans le soustracteur 44. Les deux entrées du soustracteur 44 peuvent être pondérées différemment (par les coefficients a, b) pour compenser les coefficients à l'intérieur du premier modulateur de sorte à obtenir en sortie du soustracteur 44 un signal $v_{in2}$ ne dépendant que du bruit de quantification du premier modulateur :

$$v_{in2}(z)=a.\ Q_1(z)$$

Ce signal $v_{in2}$ est ensuite numérisé par le deuxième codeur sigma delta, du premier ordre, qui délivre en sortie $Y_2$, puis mis en forme pour reproduire la fonction de transfert du premier étage.

$$Y_2(Z)=Q_1(Z)\ FTS2(z)+Q_2(Z)\ FTB2(z)$$

où $Q_2(z)$ le bruit de quantification du quantificateur du deuxième modulateur, $FTS2(z)$ la fonction de transfert du signal d'entrée du deuxième modulateur (ici $FTS2(z) \approx z^{-1}$) et $FTB2(z)$ la fonction de transfert du bruit ($FTB2(z) \approx (1-z^{-1})$).
Enfin ce signal est soustrait de la sortie du premier étage pour annuler ce bruit de quantification. Le bruit de quantification résiduel dans le signal Y est alors celui du deuxième étage qui est généralement, comme dans le cas de la figure 9, au moins un modulateur du premier ordre dont le bruit en sortie se retrouve finalement mis en forme au moins au troisième ordre (la somme des ordres des 2 modulateurs). Ces architectures cascadées sont connues pour leur stabilité inconditionnelle.

$$Y(z)=Y_1(z).z^{-1}+Y_2(z)*(1-z^{-1})^2= a_1.Vin(z).FTS1(z).FTS2(z)+Q_2(z).FTB2(z).(1-z^{-1})^2$$

en supposant que a=1, $k_5$=1 et c=0.
Dans un mode de réalisation de l'invention utilisant un tel modulateur à architecture cascadée, une décorrélation du bruit du second modulateur sigma-delta est mise en œuvre entre les différentes voies de traitement Vi, i = 0 à N-1. Des solutions très simples peuvent être implémentées. Le signal de sortie du premier modulateur peut être injecté dans le second modulateur avec un poids différent dans chacune des voies.
Par exemple, en remplaçant le coefficient a par (a+$\alpha$) sur une ou plusieurs voies de traitement avec une valeur $\alpha$ propre à la voie concernée ($\alpha = \alpha_i$ sur la voie Vi et $\alpha = \alpha_j$ sur la voie Vj, i et j distincts entre 0 et N-1 et $\alpha_{i \neq} \alpha_j$), on différentie l'entrée du second modulateur sur la voie Vi par rapport à la voie Vj.

$$Vin_2'(z)=a.Q_1(z)+ \alpha.\ a_1.Vin(z).FTS1(z)+ \alpha.Q_1(z).FTB1(z)$$

Cela revient donc à injecter dans le second modulateur une partie du signal et une partie du bruit du modulateur mis en forme, ce signal supplémentaire influençant alors le bruit de quantification du second modulateur. En prenant des valeurs différentes de $\alpha$ pour des voies de traitement Vi différentes, le bruit de chacun des modulateurs cascadés est différentié entre les voies.
Ce signal supplémentaire injecté dans le deuxième étage mis en forme par la fonction de transfert global n'aura pas d'impact sur le SNR en sortie du modulateur. Le signal subissant les étages de mise en forme de bruit après le second modulateur (par $(1-z^{-1})^2$ dans notre exemple), son influence sera nulle sur la sortie. On peut même annuler son influence en sortie du deuxième modulateur par l'intermédiaire du coefficient c, en l'adaptant à la valeur de $\alpha$.
Toute modification du second modulateur différentiant le traitement entre les voies peut être mise en œuvre : par exemple en en modifiant le quantificateur comme vu précédemment, ou encore si le second modulateur est un modulateur du deuxième ordre (avec les coefficients $k'_1$, $k'_3$ à la place des coefficients $k_1$, $k_3$ dans des blocs du second modulateur similaires aux blocs 32,35 du premier modulateur), ou différentiant les voies par des valeurs distinctes de $k'_1$ et/ou $k'_3$. Une autre solution consiste à injecter la sortie du premier modulateur dans le deuxième modulateur avec un retard variable (le même retard étant injecté aussi sur l'entrée du premier quantificateur injectée dans le deuxième modulateur ) et différent pour des voies différentes. On pourra apporter toutes sortes de modification à ce second modulateur de façon différente sur chacune des voies (ou entre au moins certaines des voies) pour garantir la décorrélation du bruit de quantification sans modifier la fonction de transfert du signal.
Une autre possibilité avec ces structures cascadées est de faire varier la valeur des coefficients $\alpha$ dans le temps avec des variations qui sont différentes d'une voie à l'autre.
L'exemple représenté en figure 9 comporte deux modulateurs sigma-delta mais il peut y avoir un nombre supérieur de modulateurs sigma-delta en cascade, le r$^{ème}$ modulateur ayant en entrée le bruit du (r-1)$^{ème}$ modulateur de rang, r>1.
Dans des modes de réalisation, certaines des différentes mises en œuvre de l'invention présentées ci-dessus sont combinées entre elles au sein d'un même système d'émission multivoies.
Idéalement, l'invention est mise en œuvre de sorte qu'il n'existe pas deux voies de traitement où le bruit de quantification obtenu est identique. Dans des modes de réalisation, au moins deux des voies de traitement présentent des bruits de quantification différents entre elles.

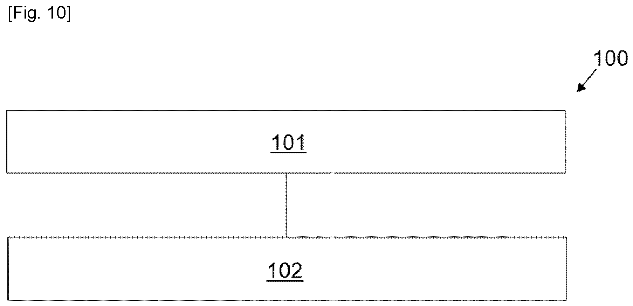

L'invention propose en outre, en référence à la figure 10, un procédé 100 de décorrélation du bruit de quantification dans un système d'émission multivoies, selon lequel :

- dans une étape 101, on traite un signal d'entrée sur une pluralité de voies de traitement parallèles Vi, i = 0 à N-1, chacune des dites voies étant couplées à un transducteur et comportant un bloc convertisseur comprenant un convertisseur CAN ou CNA et un modulateur sigma-delta,

- dans une étape 102, le fonctionnement du modulateur sigma-delta de la voie Vi est adapté par rapport au fonctionnement du modulateur sigma-delta de la voie Vj pour décorréler les bruits de quantification générés par les voies, de manière à ce que le deuxième terme de la fonction de transfert du modulateur sigma-delta pour la voie Vi soit distinct du deuxième terme de la fonction de transfert du modulateur sigma-delta pour la voie Vj, le premier terme de ladite fonction de transfert pour la voie Vi étant égal à celui pour la voie Vj.

Pour ce faire, le procédé comprend l'une et/ou l'autre des différentes adaptations décrites ci-dessus en référence au système d'émission multivoies 10.
L'invention a été décrite en outre ci-dessus dans le cadre de signaux radiofréquence, mais elle s'applique bien sûr tout aussi bien à des signaux autres, par exemple audiofréquence, ultrasons etc., l'antenne radiofréquence étant alors remplacée par un dispositif transducteur adapté au type de signaux manipulés.
En outre, l'invention a été décrite plus précisément ci-dessus en référence à un système d'émission multivoies, mais elle s'applique similairement aux systèmes de réception multivoies ou d'émission/réception multivoies, où par rapport à ce qui précède, les convertisseurs DAC sont remplacés par les convertisseurs ADC dans les voies de traitement comportant également les modulateurs sigma-delta. Il en va de même pour le procédé de décorrélation du bruit selon l'invention
L'invention s'applique bien entendu à d'autres types d'application que le beamforming.

**Revendications**

1.  Système multivoies d'émission et/ou de réception (10) comprenant au moins N voies de traitement parallèles (V0, V1), N ≥2, couplées chacune à un transducteur respectif (18) d'une pluralité de transducteurs et comportant chacune un bloc convertisseur comprenant un convertisseur CAN ou CNA (14) et un modulateur sigma-delta (12),

    la fonction de transfert du modulateur sigma-delta (12) de chaque voie Vi, i = 1 à N, étant définie comme une somme de deux termes comprenant un premier terme IN(z).FTS(z) relatif au signal et un deuxième terme Q(z).FTB(z) relatif au bruit de quantification introduit par le modulateur sigma-delta (12) et s'énonçant ainsi :

    $$OUT(z) = IN(z).FTS(z) + Q(z).FTB(z),$$

    où OUT est le signal de sortie du modulateur sigma-delta, IN est le signal d'entrée du modulateur sigma-delta, FTS est la fonction de transfert du signal d'entrée, Q est le bruit de quantification et FTB est la fonction de transfert du bruit de quantification,
    la fonction de transfert du modulateur sigma-delta d'une voie Vi étant distincte de la fonction de transfert du modulateur sigma-delta d'une voie Vj, i et j entiers distincts compris entre 1 et N, pour décorréler entre eux les bruits de quantification de voies distinctes,
    ledit système multivoies (10) étant **caractérisé en ce que**, pour des voies distinctes Vi, Vj, les deuxièmes termes de la fonction de transfert du modulateur sigma-delta uniquement sont distincts, le premier terme de ladite fonction de transfert pour la voie Vi étant égal à celui pour la voie Vj.

2.  Système multivoies d'émission et/ou de réception (10) selon la revendication 1, dans lequel le modulateur sigma-delta (12) sur chacune des voies Vi, Vj (V0, V1) comprend un quantificateur 1 bit à hystérésis, et le cycle d'hystérésis est différent entre les voies Vi, Vj en amplitude et/ou temporellement.

3.  Système multivoies d'émission et/ou de réception (10) selon la revendication 1 ou 2, dans lequel le modulateur sigma-delta (12) sur chacune des voies Vi, Vj comprend un quantificateur multibit ;
    et la valeur du signal d'entrée correspondant à la commutation entre deux niveaux de quantification sur la voie Vi est fixée distincte de la valeur du signal d'entrée correspondant à la commutation entre ces deux mêmes niveaux de quantification sur la voie Vj.

4. Système multivoies d'émission et/ou de réception (110) selon la revendication 3, comprenant sur chacune des voies Vi, Vj, au moins ledit modulateur sigma-delta (12) avec quantificateur multibit et un modulateur sigma-delta additionnel (131), la sortie de l'un desdits modulateurs étant fournie en entrée de l'autre desdits modulateurs, ledit autre modulateur sigma-delta sur la voie Vi étant identique à ledit autre modulateur sigma-delta sur la voie Vj.

5. Système multivoies d'émission et/ou de réception (10) selon l'une des revendications précédentes, dans lequel sur chacune des voies Vi, Vj, le modulateur sigma-delta est un modulateur sigma-delta (12") à architecture cascadée comprenant au moins deux étages, le premier étage comprenant un premier modulateur delta-sigma comprenant notamment un quantificateur et le deuxième étage comprenant au moins un deuxième modulateur sigma-delta ;

le deuxième étage étant adapté pour recevoir en entrée la sortie du quantificateur du premier modulateur et l'entrée du quantificateur du premier modulateur, pour numériser, via le deuxième comparateur, un signal représentatif du bruit de quantification du premier modulateur et pour le mettre en forme ;
la différence entre un signal proportionnel à la sortie du quantificateur du premier modulateur et un signal proportionnel à l'entrée du quantificateur du premier modulateur étant fournie en entrée du deuxième modulateur ;
la sortie du deuxième étage étant ensuite soustraite à la sortie du premier modulateur pour délivrer un signal dépourvu d'au moins une partie du bruit de quantification du premier étage
dans lequel le deuxième étage de la voie Vi est différent du deuxième étage sur la voie Vj de manière à différentier entre eux les bruits de quantification du deuxième modulateur des voies Vi, Vj.

6. Système multivoies d'émission et/ou de réception (10) selon la revendication 5, dans lequel le deuxième étage comporte des multiplieurs, chaque multiplieur multipliant son entrée par un coefficient associé respectif, dans lequel, en considérant au moins un desdits multiplieurs, le coefficient qui lui est associé sur la voie Vi est de valeur différente de celui sur la voie Vj.

7. Système multivoies d'émission et/ou de réception (10) selon la revendication 5 ou 6, dans lequel un bloc retardateur est disposé dans le deuxième étage, entre la sortie du premier modulateur et l'entrée du deuxième modulateur, adapté pour appliquer un retard au signal issu de ladite sortie, le retard sur la voie Vi étant fixé à une valeur différente de celle du retard sur la voie Vj.

8. Procédé de décorrélation des bruits de quantification dans un système multivoies d' émission et/ou de réception (10) comprenant au moins N voies de traitement parallèles, N $\geq$ 2, couplées chacune à un transducteur respectif (18) d'une pluralité de transducteurs et comportant chacune un bloc convertisseur comprenant un convertisseur CAN ou CNA (14) et un modulateur sigma-delta (12),

la fonction de transfert du modulateur sigma-delta (12) de chaque voie Vi, i = 1 à N, étant définie comme une somme de deux termes comprenant un premier terme IN(z).FTS(z) relatif au signal et un deuxième terme Q(z).FTB(z) relatif au bruit de quantification introduit par le modulateur sigma-delta (12) et s'énonçant ainsi :

$$OUT(z) = IN(z).FTS(z) + Q(z).FTB(z),$$

où OUT est le signal de sortie du modulateur sigma-delta, IN est le signal d'entrée du modulateur sigma-delta, FTS est la fonction de transfert du signal d'entrée, Q est le bruit de quantification et FTB est la fonction de transfert du bruit de quantification,
selon lequel le fonctionnement du modulateur sigma-delta de la voie Vi est adapté par rapport au fonctionnement du modulateur sigma-delta de la voie Vj pour décorréler les bruits de quantification générés par les voies,
la fonction de transfert du modulateur sigma-delta d'une voie Vi étant distincte de la fonction de transfert du modulateur sigma-delta d'une voie Vj, i et j entiers distincts compris entre 1 et N, pour décorréler entre eux les bruits de quantification de voies distinctes,
ledit procédé étant **caractérisé en ce que**, pour des voies distinctes Vi, Vj les deuxièmes termes de la fonction de transfert du modulateur sigma-delta uniquement sont distincts, le premier terme de ladite fonction de transfert pour la voie Vi étant égal à celui pour la voie Vj.

9. Procédé de décorrélation des bruits de quantification selon la revendication 8, selon lequel le modulateur sigma-delta (12) sur chacune des voies Vi, Vj comprend un quantificateur 1 bit à hystérésis, et le cycle d'hystérésis est différent entre les voies Vi, Vj en amplitude et/ou temporellement.

**10.** Procédé selon l'une des revendications 8 ou 9, selon lequel le modulateur sigma-delta (12) sur chacune des voies Vi, Vj comprend un quantificateur multibit ; et la valeur du signal d'entrée correspondant à la commutation entre deux niveaux de quantification sur la voie Vi est fixée distincte de la valeur du signal d'entrée correspondant à la commutation entre ces deux mêmes niveaux de quantification sur la voie Vj.

**Patentansprüche**

**1.** Mehrweg-Sende- und/oder Empfangssystem (10), das mindestens N parallele Verarbeitungswege (V0, V1), N $\geq$2, umfasst, die jeweils mit einem jeweiligen Wandler (18) einer Vielzahl von Wandlern gekoppelt sind, und jeweils einen Wandler-Block umfassen, umfassend einen CAN- oder CNA-Wandler (14) und einen Sigma-Delta Modulator (12),

wobei die Transferfunktion des Sigma-Delta Modulators (12) eines jeden Weges Vi, i = 1 bis N, als Summe von zwei Termini definiert ist, umfassend einen ersten Term IN(z).FTS(z) in Bezug auf das Signal und einen zweiten Term Q(z).FTB(z) in Bezug auf das Quantisierungsrauschen, das vom Sigma-Delta Modulator (12) eingebracht wird, und so zum Ausdruck gebracht wird:

$$OUT(z) = IN(z).FTS(z) + Q(z).FTB(z),$$

wobei OUT das Ausgangssignal des Sigma-Delta Modulators ist, IN das Eingangssignal des Sigma-Delta Modulators ist, FTS die Transferfunktion des Eingangssignals ist, Q das Quantisierungsrauschen ist und FTB die Transferfunktion des Quantisierungsrauschens ist,
wobei sich die Transferfunktion des Sigma-Delta Modulators eines Weges Vi von der Transferfunktion des Sigma-Delta Modulators eines Weges Vj unterscheidet, i und j unterschiedliche ganze Zahlen zwischen 1 und N sind, um zwischen sich die Quantisierungsrauschen unterschiedlicher Wege dekorrelieren,
wobei das Mehrweg-System (10) **dadurch gekennzeichnet ist, dass** sich für unterschiedliche Wege Vi, Vj, nur die zweiten Termini der Transferfunktion des Sigma-Delta Modulators unterscheiden, wobei der erste Term der Transferfunktion für den Weg Vi gleich dem für den Weg Vj ist.

**2.** Mehrweg-Sende- und/oder Empfangssystem (10) nach Anspruch 1, wobei der Sigma-Delta Modulator (12) auf jedem der Wege Vi, Vj (V0, V1) einen 1 Bit Quantisierer mit Hysterese umfasst, und sich der Hysterese-Zyklus zwischen den Wegen Vi, Vj in Bezug auf die Amplitude und/oder zeitlich unterscheidet.

**3.** Mehrweg-Sende- und/oder Empfangssystem (10) nach Anspruch 1 oder 2, wobei der Sigma-Delta Modulator (12) auf jedem der Wege Vi, Vj einen Mehr-Bit Quantisierer umfasst;
und der Wert des Eingangssignals, der dem Umschalten zwischen zwei Quantisierungsstufen auf dem Weg Vi entspricht, getrennt vom Wert des Eingangssignals fixiert wird, das dem Umschalten zwischen diesen beiden gleichen Quantisierungsstufen auf dem Weg Vj entspricht.

**4.** Mehrweg-Sende- und/oder Empfangssystem (110) nach Anspruch 3, das auf jedem der Wege Vi, Vj, mindestens den Sigma-Delta Modulator (12) mit Mehrbit-Quantisierer und einen zusätzlichen Sigma-Delta Modulator (131) umfasst, wobei der Ausgang des einen der Modulatoren am Eingang des anderen der Modulatoren bereitgestellt wird, wobei der andere Sigma-Delta Modulator auf dem Weg Vi dem Sigma-Delta Modulator auf dem Weg Vj identisch ist.

**5.** Mehrweg-Sende- und/oder Empfangssystem (10) nach einem der vorstehenden Ansprüche, wobei auf jedem der Wege Vi, Vj, der Sigma-Delta Modulator ein Sigma-Delta Modulator (12") mit Kaskadenarchitektur ist, der mindestens zwei Stufen umfasst, wobei die erste Stufe einen ersten Sigma-Delta Modulator umfasst, der insbesondere einen Quantisierer umfasst, und die zweite Stufe mindestens einen zweiten Sigma-Delta Modulator umfasst;

wobei die zweite Stufe angepasst ist, um am Eingang den Ausgang des Quantisierers des ersten Modulators und den Eingang des Quantisierers des ersten Modulators zu empfangen, um über den zweiten Komparator ein Signal zu digitalisieren, das repräsentativ für das Quantisierungsrauschen des ersten Modulators ist, und um es in Form zu bringen;
wobei die Differenz zwischen einem proportionalen Signal am Ausgang des Quantisierers des ersten Modulators und einem proportionalen Signal am Eingang des Quantisierers des ersten Modulators am Eingang des zweiten Modulators bereitgestellt wird;
wobei der Ausgang der zweiten Stufe danach am Ausgang des ersten Modulators subtrahiert wird, um ein Signal abzugeben, das ohne mindestens einen Teil des Quantisierungsrauschens der ersten Stufe ist

wobei sich die zweite Stufe des Weges Vi von der zweiten Stufe auf dem Weg Vj unterscheidet, um zwischen sich die Quantisierungsrauschen des zweiten Modulators der Wege Vi, Vj zu differenzieren.

6. Mehrweg-Sende- und/oder Empfangssystem (10) nach Anspruch 5, wobei die zweite Stufe Multiplizierer umfasst, wobei jeder Multiplizierer seinen Eingang mit einem jeweiligen zugeordneten Koeffizienten multipliziert, wobei unter Berücksichtigung mindestens eines der Multiplizierer der ihm auf dem Weg Vi zugeordnete Koeffizient einen anderen Wert als jener auf dem Weg Vj aufweist.

7. Mehrweg-Sende- und/oder Empfangssystem (10) nach Anspruch 5 oder 6, wobei ein Verzögerungsblock auf der zweiten Stufe, zwischen dem Ausgang des ersten Modulators und dem Eingang des zweiten Modulators angeordnet ist, der angepasst ist, um eine Verzögerung auf das aus dem Ausgang stammende Signal anzuwenden, wobei die Verzögerung auf dem Weg Vi auf einen anderen Wert als jenen der Verzögerung auf dem Weg Vj fixiert ist.

8. Verfahren zum Dekorrelieren von Quantisierungsrauschen in einem Mehrweg-Sende- und/oder Empfangssystem (10), das mindestens N parallele Verarbeitungswege, $N \geq 2$, umfasst, die jeweils mit einem jeweiligen Wandler (18) einer Vielzahl von Wandlern gekoppelt sind, und jeweils einen Wandler-Block umfassen, umfassend einen CAN- oder CNA-Wandler (14) und einen Sigma-Delta Modulator (12),

wobei die Transferfunktion des Sigma-Delta Modulators (12) eines jeden Weges Vi, i = 1 bis N, als Summe von zwei Termini definiert ist, umfassend einen ersten Term IN(z).FTS(z) in Bezug auf das Signal und einen zweiten Term Q(z).FTB(z) in Bezug auf das Quantisierungsrauschen, das vom Sigma-Delta Modulator (12) eingebracht wird, und so zum Ausdruck gebracht wird:

$$OUT(z) = IN(z).FTS(z) + Q(z).FTB(z),$$

wobei OUT das Ausgangssignal des Sigma-Delta Modulators ist, IN das Eingangssignal des Sigma-Delta Modulators ist, FTS die Transferfunktion des Eingangssignals ist, Q das Quantisierungsrauschen ist und FTB die Transferfunktion des Quantisierungsrauschens ist,
wobei der Betrieb des Sigma-Delta Modulators des Weges Vi in Bezug auf den Betrieb des Sigma-Delta Modulators des Weges Vj angepasst ist, um das durch die Wege erzeugte Quantisierungsrauschen zu dekorrelieren,
wobei sich die Transferfunktion des Sigma-Delta Modulators eines Weges Vi von der Transferfunktion des Sigma-Delta Modulators eines Weges Vj unterscheidet, i und j unterschiedliche ganze Zahlen zwischen 1 und N sind, um zwischen sich die Quantisierungsrauschen unterschiedlicher Wege dekorrelieren,
wobei das Verfahren **dadurch gekennzeichnet ist, dass** sich für unterschiedliche Wege Vi, Vj, nur die zweiten Termini der Transferfunktion des Sigma-Delta Modulators unterscheiden, wobei der erste Term der Transferfunktion für den Weg Vi gleich dem für den Weg Vj ist.

9. Verfahren zum Dekorrelieren von Quantisierungsrauschen nach Anspruch 8, wobei der Sigma-Delta Modulator (12) auf jedem der Wege Vi, Vj einen 1 Bit Quantisierer mit Hysterese umfasst, und sich der Hysterese-Zyklus zwischen den Wegen Vi, Vj in Bezug auf die Amplitude und/oder zeitlich unterscheidet.

10. Verfahren nach einem der Ansprüche 8 oder 9, wobei der Sigma-Delta Modulator (12) auf jedem der Wege Vi, Vj einen Mehrbit-Quantisierer umfasst; und der Wert des Eingangssignals, der dem Umschalten zwischen zwei Quantisierungsstufen auf dem Weg Vi entspricht, getrennt vom Wert des Eingangssignals fixiert wird, das dem Umschalten zwischen diesen beiden gleichen Quantisierungsstufen auf dem Weg Vj entspricht.

**Claims**

1. Multichannel transmit and/or receive system (10) comprising at least N parallel processing channels (V0, V1), $N \geq 2$, each coupled to a respective transducer (18) of a plurality of transducers and each comprising a converter block comprising an ADC or DAC converter (14) and a sigma-delta modulator (12),

the transfer function of the sigma-delta modulator (12) of each channel Vi, i = 1 to N, being defined as a sum of two terms comprising a first term IN(z).FTS(z) relative to the signal and a second term Q(z).FTB(z) relative to the quantization noise introduced by the sigma-delta modulator (12) and expressed as such:

$$OUT(z) = IN(z).FTS(z) + Q(z).FTB(z),$$

where OUT is the output signal of the sigma-delta modulator, IN is the input signal of the sigma-delta modulator, FTS is the transfer function of the input signal, Q is the quantization noise and FTB is the transfer function of the quantization noise,

the transfer function of the sigma-delta modulator of a channel Vi being distinct from the transfer function of the sigma-delta modulator of a channel Vj, i and j distinct integers between 1 and N, in order to decorrelate the quantization noise of distinct channels,

said multichannel system (10) **characterized in that**, for distinct channels Vi, Vj, the second terms of the transfer function of the sigma-delta modulator only are distinct, the first term of said transfer function for the channel Vi being equal to that for the channel Vj.

2. Multichannel transmit and/or receive system (10) according to claim 1, wherein the sigma-delta modulator (12) on each of the channels Vi, Vj (V0, V1) comprises a 1-bit hysteresis quantizer, and the hysteresis cycle is different between the channels Vi, Vj in amplitude and/or temporally.

3. Multichannel transmit and/or receive system (10) according to claim 1 or 2, wherein the sigma-delta modulator (12) on each of the channels Vi, Vj comprises a multi-bit quantizer;
and the value of the input signal corresponding to the switching between two levels of quantification on the channel Vi is set distinct from the value of the input signal corresponding to the switching between these two same levels of quantification on the channel Vj.

4. Multichannel transmit and/or receive system (110) according to claim 3, comprising on each of the channels Vi, Vj, at least said sigma-delta modulator (12) with multi-bit quantizer and an additional sigma-delta modulator (131), the output of one of said modulators being supplied as input of the other of said modulators, said other sigma-delta modulator on the channel Vi being identical to said other sigma-delta modulator on the channel Vj.

5. Multichannel transmit and/or receive system (10) according to one of the preceding claims, wherein on each of the channels Vi, Vj, the sigma-delta modulator is a cascaded architecture sigma-delta modulator (12") comprising at least two stages, the first stage comprising a first sigma-delta modulator comprising in particular a quantizer and the second stage comprising at least one second sigma-delta modulator;

the second stage being adapted to receive as input the output from the quantizer of the first modulator and the input of the quantizer of the first modulator, to digitize, via the second comparator, a signal representative of the quantization noise of the first modulator and to format it;
the difference between a signal proportional to the output of the quantizer of the first modulator and a signal proportional to the input of the quantizer of the first modulator being supplied as input of the second modulator;
the output of the second stage then being subtracted from the output of the first modulator to deliver a signal devoid of at least a part of the quantization noise of the first stage
wherein the second stage of the channel Vi is different from the second stage on the channel Vj in such a way as to differentiate between them the quantization noises of the second modulator of channels Vi, Vj.

6. Multichannel transmit and/or receive system (10) according to claim 5, wherein the second stage comprises multipliers, each multiplier multiplying its input by a respective associated coefficient, wherein, by considering at least one of said multipliers, the coefficient that it is associated with on the channel Vi is of a value different from that on the channel Vj.

7. Multichannel transmit and/or receive system (10) according to claim 5 or 6, wherein a delay block is arranged in the second stage, between the output of the first modulator and the input of the second modulator, adapted to apply a delay to the signal coming from said output, the delay of the channel Vi being set to a value different from that on the channel Vj.

8. Method for decorrelating quantization noises in a multichannel transmit and/or receive system (10) comprising at least N parallel processing channels, N≥2, each coupled to a respective transducer (18) of a plurality of transducers and each comprising a converter block comprising an ADC or DAC converter (14) and a sigma-delta modulator (12),

the transfer function of the sigma-delta modulator (12) of each channel Vi, i = 1 to N, being defined as a sum of two terms comprising a first term IN(z).FTS(z) relative to the signal and a second term Q(z).FTB(z) relative to the quantization noise introduced by the sigma-delta modulator (12) and expressed as such:

$$OUT(z) = IN(z).FTS(z) + Q(z).FTB(z),$$

where OUT is the output signal of the sigma-delta modulator, IN is the input signal of the sigma-delta modulator, FTS is the transfer function of the input signal, Q is the quantization noise and FTB is the transfer function of the quantization noise,
according to which the operation of the sigma-delta modulator of the channel Vi is adapted with respect to the operation of the sigma-delta modulator of the channel Vj in order to decorrelate the quantization noises generated by the channels,
the transfer function of the sigma-delta modulator of a channel Vi being distinct from the transfer function of the sigma-delta modulator of a channel Vj, i and j distinct integers between 1 and N, in order to decorrelate the quantization noise of distinct channels,
said method **characterized in that**, for distinct channels Vi, Vj the second terms of the transfer function of the sigma-delta modulator only are distinct, the first term of said transfer function for the channel Vi being equal to that for the channel Vj.

9.  Method for decorrelating quantization noises according to claim 8, according to which the sigma-delta modulator (12) on each of the channels Vi, Vj comprises a 1-bit hysteresis quantizer, and the hysteresis cycle is different between the channels Vi, Vj in amplitude and/or temporally.

10. Method according to one of claims 8 or 9, according to which the sigma-delta modulator (12) on each of channels Vi, Vj comprises a multi-bit quantizer; and the value of the input signal corresponding to the switching between two levels of quantification on the channel Vi is set distinct from the value of the input signal corresponding to the switching between these two same levels of quantification on the channel Vj.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

100

101

102

**EP 4 333 313 B1**

## RÉFÉRENCES CITÉES DANS LA DESCRIPTION

**Documents brevets cités dans la description**

- WO 2020105040 A1

- US 2017012679 A1